**Europäisches Patentamt**

**European Patent Office**

**Office européen des brevets**

(11) Publication number: **0 033 230**
**B1**

(12) **EUROPEAN PATENT SPECIFICATION**

(45) Date of publication of patent specification: **14.08.85**

(21) Application number: **81300297.9**

(22) Date of filing: **22.01.81**

(51) Int. Cl.⁴: **H 01 L 27/14**

(54) Solid-state imaging device

(30) Priority: **23.01.80 JP 5756/80**

(43) Date of publication of application:
**05.08.81 Bulletin 81/31**

(45) Publication of the grant of the patent:
**14.08.85 Bulletin 85/33**

(84) Designated Contracting States:
**DE FR GB NL**

(56) References cited:
**FR-A-2 378 412**
**GB-A-2 014 783**

(73) Proprietor: **Hitachi, Ltd.**
**5-1, Marunouchi 1-chome**
**Chiyoda-ku Tokyo 100 (JP)**

(72) Inventor: **Baji, Toru**
**3-1-3, Higashi-koigakubo**
**Kokubunji-shi Tokyo (JP)**
Inventor: **Tsukada, Toshihisa**
**4-kou704-17-B405, Sekimachi**
**Nerima-ku Tokyo (JP)**
Inventor: **Koike, Norio**
**2-23-13, Minami-ogikubo**
**Suginami-ku Tokyo (JP)**
Inventor: **Yamamoto, Hideaki**
**2-32-A404, Koyasu-cho**
**Hachioji-shi Tokyo (JP)**
Inventor: **Takasaki, Yuki**
**1-47-1-D401, Akatsuki-cho**
**Hachioji-shi Tokyo (JP)**
Inventor: **Takemoto, Iwao**
**2196-458, Hirai Hinodemachi**
**Nishitama-gun Tokyo (JP)**

(74) Representative: **Paget, Hugh Charles Edward**
**et al**
**MEWBURN ELLIS & CO. 2/3 Cursitor Street**
**London EC4A 1BQ (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention relates to improvements in a solid-state imaging device according to the precharacterising part of claim 1. Such a device is known from GB—A—2014783.

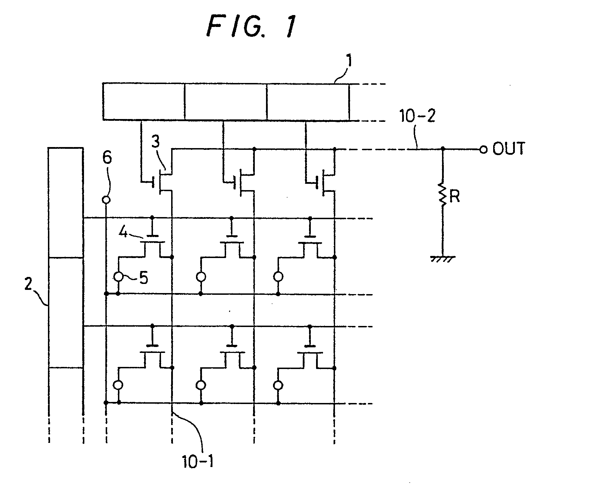

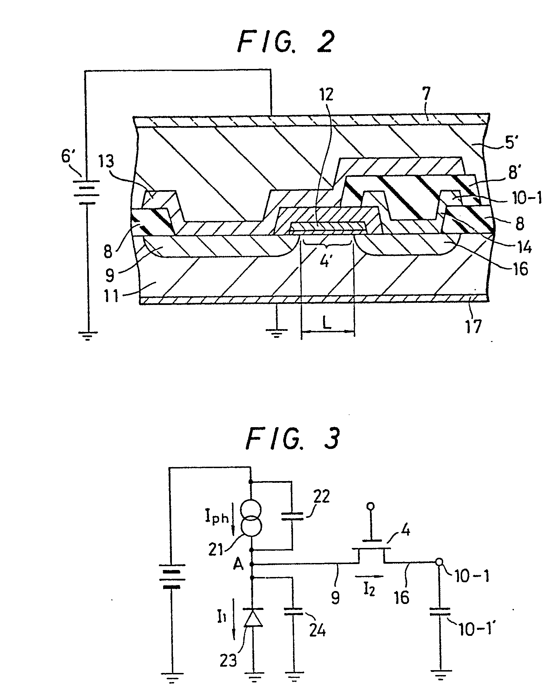

In one known solid-state imaging device, scanners and groups of switches connected thereto are arrayed on a semiconductor substrate and are overlaid with a thin photoconductive film for the photoelectric conversion function. Owing to the double-layer structure in which photoelectric elements are formed over the scanners and the groups of switches, this device enhances the packaging density of picture elements (in other words, the resolving power) and the light receiving efficiency, and is therefore expected to be used as a practical solid-state imaging device in the future. Examples of solid-state imaging devices of this type are disclosed in Japanese Published Unexamined Patent Application No. 51—10715 (filed 5 July 1974); International Electron Devices Meeting, December 1979, pp. 134—136; etc. Figure 1 shows a construction for explaining the principle of the device. In Figure 1, numeral 1 designates a horizontal scanner which turns "on" and "off" horizontal position selecting switches 3; numeral 2 a vertical scanner which turns "on" and "off" vertical position selecting switches 4, numeral 5 a photoelectric element which utilizes a thin photoconductive film, numeral 6 a supply voltage terminal which serves to drive the photoelectric elements 5, numerals 10-1 and 10-2 signal output lines, and letter R a resistor. Figure 2 shows a sectional structure of a photoelectric conversion region in Figure 1, in which numeral 5' indicates a thin photoconductive film, numeral 6' a supply voltage applied through a transparent electrode 7, numeral 4' a vertical switch and numeral 8 an insulating film. Numeral 11 indicates a semi-conductor substrate, numeral 12 a gate electrode, and numeral 13 an electrode (of, for example, A1) which is held in ohmic contact with one end 9 (a diffused region formed by the use of an impurity of opposite conductivity type to the substrate 11) of the switch 4'. When an optical image is formed on the thin photoconductive film through a lens, the resistance value of the photoconductive film varies depending upon the light intensities of the optical image. A voltage variation corresponding to the optical image appears at the end 9 of the vertical switch 4 (4'), and this variation is derived as a video signal from an output terminal OUT through the signal output lines 10-1 and 10-2. An impurity diffused region which has the same conductivity type as that of the region 9 is connected to the signal output line 10-1.

In such solid-state imaging devices, blooming develops, in a unique shape determined by the scanning system. In the foregoing example, the voltage of the region 9 in Figure 2 will rise in response to a spot of high illumination and exceed the voltage which the switch is capable of withstanding. Therefore, signal charges pour from the region 9 to the region 16 connected to the line 10-1, giving rise to blooming in the shape of stripes extending vertically on the imaging screen. It degrades the picture quality conspicuously and is a particular problem.

According to this invention there is provided a solid-state imaging device comprising a semi-conductor integrated circuit in which a plurality of switching elements are disposed on a substrate, the switching elements being adapted for selecting positions of picture elements by turning "on" and "off" the switching elements in time sequence, suitably by means of scanners also disposed on the substrate; a photoconductive film which is disposed on the integrated circuit and which is connected to one end of each of the switching elements; and a light transmitting electrode which is disposed on the photoconductive film; each of the switching elements including first and second impurity regions in the semiconductor substrate which have a conductivity type opposite to that of the semi-conductor substrate, one of the impurity regions acting to store carriers generated with incidence of light; and means for controlling current in a current path between the two impurity regions; characterised in that the breakdown voltage of a junction formed between the semiconductor substrate and an impurity region which stores carriers with incidence of light is made smaller than the breakdown voltage between said first and second impurity regions.

Embodiments of the invention will be described with reference to the drawings, in which:

Figure 1 is a diagram showing the outline of a solid-state imaging device which employs a photoconductive film as a photoelectric conversion portion,

Figure 2 is a sectional view showing a picture element of an embodiment of a solid-state imaging device of this invention which employs a photoconductive film as a photoelectric conversion portion,

Figures 3 and 4 are equivalent circuit diagrams of picture element portions,

Figures 5, 6 and 7 are sectional views of essential portions showing different embodiments of this invention, and

Figure 8 is a diagram showing the relationship between the photo current and the voltage applied to a photoconductive film.

The essential point of the embodiments of this invention is that, in a solid-state imaging device whose fundamental construction is exemplified in Figure 2, the relationship between the punch-through voltage of the switching element 4' (the breakdown voltage, $BV_{DS}$ between the impurity diffused regions 9 and 16 which constitute the switch 4') and the breakdown voltage ($BV_j$) of the diode junction which is formed between the semiconductor substrate 11 and the impurity region 9 in the substrate is made such that:

$$BV_{DS} > BV_j$$

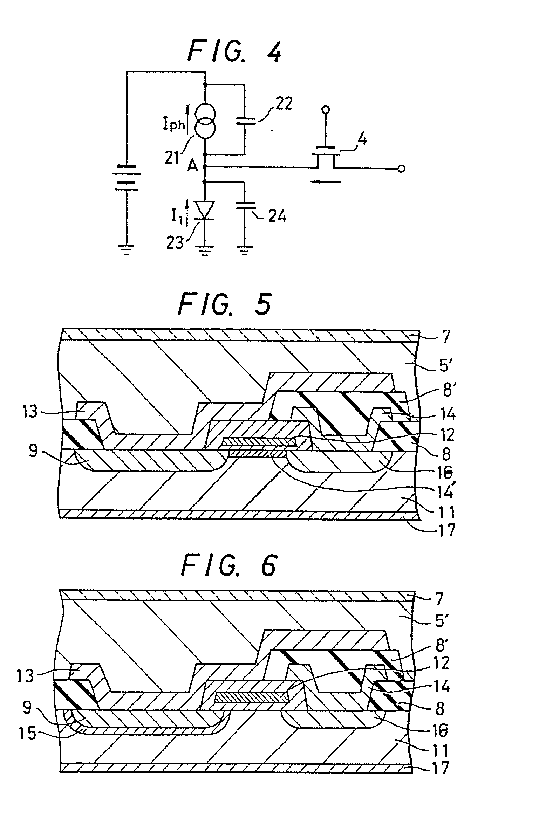

Figure 3 shows an equivalent circuit of one picture element. Numeral 4 indicates the same switch as in Figure 1. Parts 21 and 22 correspond to the thin photoconductive film 5, and are respectively an equivalent photo current source and the capacitance of the thin photoconductive film 5. Parts 23 and 24 correspond to the impurity region 9, and are respectively a diode formed by a p-n junction or n-p junction and the junction capacitance thereof. Figure 4 shows an equivalent circuit in the case where the conductivity types of the semiconductor material and the impurity regions are reversed. The same symbols indicate the same parts. Although the senses of currents etc. are opposite, the fundamental electrical operations may be similarly considered. A part 10-1' is a capacitance parasitic to the vertical output line 10-1.

Immediately after external light has been read, the potential of a point A in Figure 3 is reset to a video bias voltage $V_V$. Thereafter, the capacitance 22 ($C_a$) of the thin photoconductive film is discharged and the diffusion capacitance 24 ($C_d$) is charged by the photo current $I_{ph}$ of the thin photoconductive film over a storage time $\tau_s$. As carriers created by the light are stored in the capacitances $C_a$ and $C_d$ in this manner, the potential of the point A rises gradually. In the present device, the potential of the point A is expressed as:

$$V = \frac{I_{ph} \cdot \tau_s}{C_a + C_d}$$

where $I_{ph}$ denotes the photo current of the thin photoconductive film, $\tau_s$ the storage time (33 msec in ordinary TV cameras), and $C_a$ and $C_d$ the capacitances of the thin photoconductive film and the diffused portion respectively.

In reading out the stored signal charges, the switch 4 is turned "on" to transmit the signal charges to the parasitic capacitance 10-1' of the vertical signal line. Subsequently, the switch 3 is turned "on" to read out the charges through the load resistor R connected to the output line 10-2.

Now, by fulfilling the condition of $BV_{DS} > BV_j$ as stated previously, an effect described below can be achieved. The difference between the voltages $BV_{DS}$ and $BV_j$ is in practice made approximately 0.5—1V or more, though it is dependent upon the design of the imaging device.

With rise in the intensity of illumination, the potential of the point A rises. Since, however, the breakdown voltage $BV_{DS}$ of the switching element 4 (that is, 4' in Figure 2) is set to be greater than the breakdown voltage $BV_j$ of the junction diode 23, the junction diode breaks down first. Accordingly, the potential of the point A does not rise any more. The signal current is also saturated by the illumination at that time.

Also excess carriers created at an extraordinarily high illumination pour entirely towards the substrate 11 owing to the aforecited breakdown of the junction diode. Accordingly, the blooming which has been observed in the prior-art device and which is attributed to the leakage of the excess carriers to the signal line does not appear.

The following methods may be used to establish the foregoing condition $BV_{DS} > BV_j$:

(1) The impurity concentration $N_a$ of the channel portion of the switch 4 may be made higher than the rest of the substrate. Figure 5 shows a sectional view of a device illustrative of this structure. The sectional view corresponds to one picture element. Numeral 14' indicates the region whose impurity concentration is made high (though still of the same conductivity type as the substrate). The other numerals are the same as in Figure 2. The breakdown voltage $BV_{DS}$ can thus be raised.

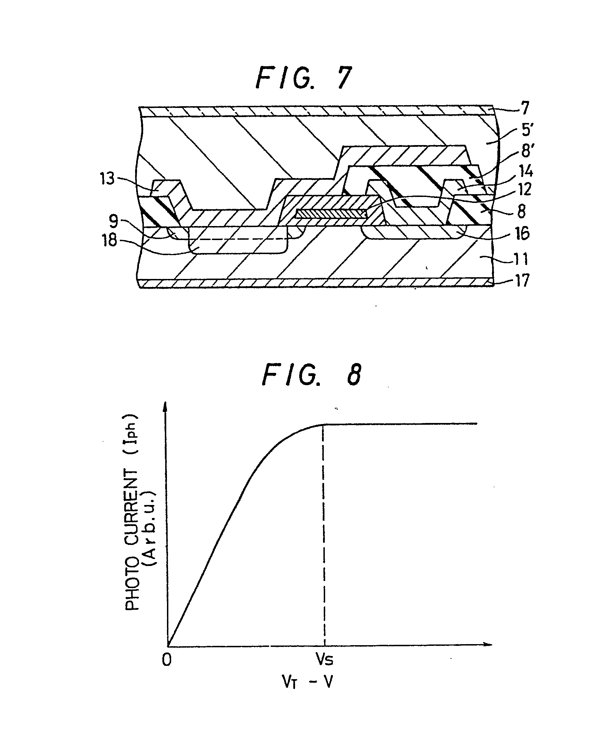

(2) A heavily-doped region of the substrate may be disposed in the vicinity of the impurity region 9. In this case, the heavily-doped region may be disposed across the whole area of the impurity region 9 or may well be disposed across only a part thereof. Figure 6 is a sectional view of a device showing an example in which such a heavily-doped region is formed. As before, this sectional view corresponds to the portion of one picture element. Numeral 15 indicates the heavily-doped region which is disposed in the vicinity of the impurity region 9. It is of the same conductivity type as the substrate but with a higher impurity concentration than the substrate, and it surrounds the region 9. The other numerals are the same as in Figure 2.

In general, the semiconductor substrate used has an impurity concentration of the order of $5 \times 10^4$—$5 \times 10^5$/cm$^3$. In the above examples, accordingly, the impurity concentrations of the more heavily doped regions are usually made approximately $10^{16}$—$10^{18}$/cm$^3$.

The impurity region 9 and the heavily-doped region 15 exemplified in Figure 6 are satisfactorily formed by the double diffusion process which is employed in the field of general semiconductor devices.

Figure 7 is a sectional view of a device showing an example in which a heavily-doped region 18 is disposed in a part of the impurity region 9. The same symbols as in Figure 2 indicate the same parts.

Since the semiconductor substrate usually has an impurity concentration of the order of $5 \times 10^{14}$—$5 \times 10^{15}$/cm$^3$, a p$^+$-type impurity region having an impurity concentration of approximately $10^{16}$—$10^{17}$/cm$^3$ is formed as the heavily-doped region 18 by diffusing boron. Subsequently, an impurity region having an impurity concentration of at least $10^{20}$/cm$^3$ is produced by diffusing phosphorus, to form the n-type impurity region 9. In an example, characteristics of $BV_j = 16V$ and $BV_{DS} = 23V$ were obtained with a channel length of 5 μm, and blooming could be completely prevented.

In forming the impurity regions, techniques used in the field of ordinary semiconductor devices are satisfactory.

The following methods can also be used. Both have some difficulties, and designs need to be contrived in practical use.

(3) The impurity concentration $N_A$ of the semiconductor substrate 11 can be made high. In general, it is made approximately $10^{16}$—$10^{18}$/cm$^3$. Thus, it is possible to raise the breakdown voltage $BV_{DS}$ and simultaneously lower the breakdown voltage $BV_j$. This method, however, has the difficulty that the threshold voltage of the switching element rises.

(4) As another method, the channel length of the switch 4 can be made large. However, the increase of the channel length results in enlarging the size of each picture element and lowering the packaging density of picture elements. In practice, therefore, channel lengths have their upper limit determined by the size of the picture element, and this method is comparatively difficult to use.

In the solid-state imaging device of this invention, it is favorable to use the photoconductive film in the saturation region as stated before. Figure 8 is a diagram showing the relationship between the photo current ($I_{ph}$) and the voltage applied to the photoconductive film. $V_s$ indicates the saturation point. A reduced after-image, a high quantum efficiency and a short lag can be realised by using the device in this state. The reason why such characteristics are attained in the saturation region by applying a sufficient voltage (electric field) of or above $V_S$ is that those photo carriers in the photoconductive film which are generated in the vicinity of the transparent electrode then migrate to the counter electrode quickly without being trapped halfway.

Now, in the equivalent circuit of Figure 3, the diode 23 has a breakdown voltage ($BV_j$), and hence, the maximum value of the potential of the point A is $BV_j$. The minimum value of the voltage applied to the photoconductive film is expressed as $V_T - BV_j$ (where $V_T$: bias voltage). In order to use the photoconductive film in the saturation region, accordingly, $V_T - BV_j \geqq V_S$ (where $V_S$: saturation point of the voltage applied to the photoconductive film) may be satisfied.

Therefore, the condition of the breakdown voltage $BV_j$ becomes $V_T - V_S \geqq BV_j$.

In an example of $V_S = 30V$, cases where $(V_T - V)$ is 15V and where it is 40V will be compared. At 5 seconds after the interception of light, 6% of the photo current during the interception remains in the former case, whereas about 0.2% remains in the latter case. It can thus be seen that this measure is extraordinarily effective.

Since the fundamental structure of the examples is as shown in Figure 5, it will be explained in more detail. A scanning circuit portion including a switching circuit etc. was produced on the semiconductor substrate by processes used for ordinary semiconductor devices. A thin $SiO_2$ film of approximately 80 nm was formed on a p-type silicon substrate 11, and an $Si_3N_4$ film of approximately 1 40 nm was formed on predetermined positions of the $SiO_2$ film. The $SiO_2$ film was formed by the conventional CVD process, and the $Si_3N_4$ film by a CVD process in which $Si_3N_4$ and $N_2$ were caused to flow. Subsequently, the silicon was locally oxidised in an atmosphere of $H_2:O_2 = 1:8$, to form an $SiO_2$ layer 8. This method is the local oxidation of silicon for isolating elements and is generally termed "LOCOS". The $Si_3N_4$ film and the $SiO_2$ film stated above were then removed, and a gate insulating film for each MOS transistor was formed of an $SiO_2$ film.

Subsequently, a gate portion 12 of polycrystalline silicon and diffused regions 9 and 16 were formed, and an $SiO_2$ film was further formed thereon. In this film, an electrode lead-out opening for the impurity region 16 was provided by etching. An aluminium electrode 14 was evaporated to 8 00 nm thickness, forming the line 10-1. Further, an $SiO_2$ film 8' was formed to 7 50 nm. Subsequently, on the impurity region 9, an electrode lead-out opening for the region 9 was provided by etching, and Al or Mo was evaporated to 1 μm thickness forming an electrode 13. The electrode 13 was formed to be so extensive to cover the regions 9 and 16 and the gate portion. This is because the incidence of light on signal processing regions between the picture elements is a cause of blooming and is undesirable.

A recombination layer of $Sb_2S_3$ or the like may be optionally disposed on the aluminium electrode 13.

The manufacture of the semiconductor device portion described above may satisfactorily rely on the ordinary MOSIC manufacturing process as disclosed in, for example, the official gazette of Japanese Published Unexamined Patent Application No. 53—122316.

Subsequently, the semiconductor body prepared by the steps thus far described was installed on a magnetron type sputtering equipment. An atmosphere of a mixed gas consisting of Ar and hydrogen was used and was under 0.2 Torr (0.266 mbar). The hydrogen content was 6 mol-%. As a sputtering target, silicon was used. Reactive sputtering was carried out at a frequency of 13.56 MHz and an input power of 300W, to deposit a thin amorphous silicon film 5' containing hydrogen on the semiconductor body to a thickness of 500 nm. The hydrogen content of the thin amorphous film was 20 atomic-%, and the resistivity thereof was $5 \times 10^{13} \Omega$.cm.

Subsequently, a $SnO_2$ layer 1 00 nm—2 μm thick was formed on the film 5' to provide a transparent electrode 7. A second electrode 17 was formed as an Au layer on the rear surface of the semiconductor substrate. In general, the semiconductor substrate is grounded through the electrode 17.

Needless to say, the photoconductive film 5' is not restricted to this example. It may be any of various films, for example, an Se-As-Te film or a multilayered film consisting of layers of the components, and a two-element film of Zn-Se and Zn-Cd-Te.

Table 1 sums up the parameters of the impurity concentration of the semi-conductor substrate 11 (boron was introduced by ion implantation), the channel length of the switching element, etc. Example Nos. 1—3 are examples of structures in which the high concentration impurity region was disposed only in the channel portion of the switch 4. In this case, the impurity concentration of the substrate was $1\times10^{15}/cm^3$. The depth of the high concentration impurity region sufficed to be approximately 0.05—0.5 µm.

Example Nos. 4—5 are comparative examples in the case where the impurity concentration of the substrate was $1\times10^{15}/cm^3$.

The impurity region 9 (and 16) had its impurity concentration made $10^{19}$—$10^{20}/cm^3$ and its diffusion depth made 0.5—1 µm.

This invention has thus far been described in terms of examples in which the switching elements etc. are disposed directly in the semiconductor substrate. Needless to say, however, this invention is also applicable to, for example, a structure wherein a well of the opposite conductivity type is formed in a semiconductor substrate and wherein switching elements etc. similar to those described before are disposed in the well. References in this application to the semiconductor substrate should therefore be construed accordingly.

TABLE 1

| Example No. | $N_A$ (/cm³) | Channel length (µm) | $BV_j$ (V) | $BV_{DS}$ (V) |
|---|---|---|---|---|
| 1 | $5\times10^{16}$ | 15 | 16 | 20 or above |
| 2 | $5\times10^{16}$ | 8 | 16 | 18 or above |
| 3 | $5\times10^{16}$ | 5 | 16 | 17 or above |
| Comparative Examples 4 | $1\times10^{15}$ | 15 | 27 | 20 or below |
| 5 | $1\times10^{15}$ | 4 | 27 | 17 or below |

## Claims

1. A solid-state imaging device comprising: a semiconductor integrated circuit in which a plurality of switching elements (4, 4') are disposed on a semiconductor substrate (11), the switching elements being adapted for selecting positions of picture elements by turning "on" and "off" the switching elements in time sequence; a photoconductive film (5') which is disposed on the integrated circuit and which is connected to one end (9) of each of the switching elements; and a light transmitting electrode (7) which is disposed on the photoconductive film; each of the switching elements including first and second impurity regions (9, 16) in the semiconductor substrate which have a conductivity type opposite to that of the semiconductor substrate, one of the impurity regions (9) acting to store carriers generated with incidence of light; and means (12) for controlling current in a current path between the two impurity regions; characterised in that the breakdown voltage ($BV_j$) of the junction which is formed between said semiconductor substrate (11) and the impurity region (9) which stores carriers generated with incidence of light is made smaller than the breakdown voltage ($BV_{DS}$) between said first and second impurity regions (9, 16).

2. A solid-state imaging device according to claim 1, wherein a semiconductor region (14') between said first and second impurity regions (9, 16) has the same conductivity type as that of said semiconductor substrate (11) and has an impurity concentration higher than that of said semiconductor substrate, whereby $BV_j<BV_{DS}$ is established.

3. A solid-state imaging device according to claim 1, wherein a region (15, 18) which has the same conductivity type as that of said semiconductor substrate and which has an impurity concentration higher than that of said semiconductor substrate is disposed in the vicinity of the impurity region (9) for storing carriers generated with incidence of light, whereby $BV_j<BV_{DS}$ is established.

4. A solid-state imaging device according to claim 3 wherein the region (15) with the higher impurity concentration surrounds the impurity region (9) for storing carriers.

5. A solid-state imaging device according to claim 3, wherein the region (18) which had the higher impurity concentration is disposed in contact with a part of said impurity region (9) for storing carriers generated with incidence of light.

6. A solid-state imaging device according to any one of the preceding claims, wherein scanners (1, 2) arranged to turn the switching elements "on" and "off" in time sequence are disposed on the semiconductor substrate.

**Patentansprüche**

1. Festkörper-Bildaufnahmevorrichtung, umfassend: eine integrierte Halbleiterschaltung, in der auf einem Halbleitersubstrat (11) eine Vielzahl von Schaltelementen (4, 4') angeordnet ist, die zum Anwählen von Positionen von Bildelementen durch "Ein"- und "Aus"-Schalten der Schaltelemente in zeitlicher Folge ausgelegt sind; einem auf der integrierten Schaltung angeordneten photoleitfähigen Film (5'), der mit einem Ende (9) jedes der Schaltelemente verbunden ist; eine auf dem photoleitfähigen Film angeordnete lichtdurchlässige Elektrode (7); wobei jedes der Schaltelemente einen ersten und einen zweiten Störstoffbereich (9, 16) in dem Halbleitersubstrat mit zu diesem entgegengesetztem Leitfähigkeitstyp aufweist, wobei einer der Störstoffbereiche (9) zur Speicherung von bei Lichteinfall erzeugten Ladungsträgern dient; und eine Einrichtung (12) zur Steuerung des Stroms in einem Strompfad zwischen den beiden Störstoffbereichen; dadurch gekennzeichnet, daß die Durchbruchspannung $(BV_j)$ des Übergangs, der zwischen dem Halbleitersubstrat (11) und demjenigen Störstoffbereich (9) ausgebildet ist, der bei Lichteinfall erzeugte Ladungsträger speichert, kleiner ist als die Durchbruchspannung $(BV_{DS})$ zwischen dem ersten und dem zweiten Störstoffbereich (9, 16).

2. Festkörper-Bildaufnahmevorrichtung nach Anspruch 1, wobei ein Halbleiterbereich (14') zwischen dem ersten und dem zweiten Störstoffbereich (9, 16) den gleichen Leitfähigkeitstyp hat wie das Halbleitersubstrat (11) und eine höhere Störstoffkonzentration als das Halbleitersubstrat, so daß $BV_j < BV_{DS}$ gilt.

3. Festkörper-Bildaufnahmevorrichtung nach Anspruch 1, wobei ein Bereich (15, 18), der den gleichen Leitfähigkeitstyp hat wie das Halbleitersubstrat und eine höhere Störstoffkonzentration als das Halbleitersubstrat, in der Nähe des Störstoffbereichs (9) zur Speicherung von bei Lichteinfall erzeugten Ladungsträgern angeordnet ist, so daß $BV_j < BV_{DS}$ gilt.

4. Festkörper-Bildaufnahmevorrichtung nach Anspruch 3, wobei der Bereich (15) mit der höheren Störstoffkonzentration den Störstoffbereich (9) zur Speicherung von Ladungsträgern umgibt.

5. Festkörper-Bildaufnahmevorrichtung nach Anspruch 3, wobei der Bereich (18), der die höhere Störstoffkonzentration hat, in Berührung mit einem Teil des Störstoffbereichs (9) zur Speicherung von bei Lichteinfall erzeugten Ladungsträgern angeordnet ist.

6. Festkörper-Bildaufnahmevorrichtung nach einem der vorhergehenden Ansprüche, wobei Abtasteinrichtungen (1, 2) zum "Ein"- und "Aus"-Schalten der Schaltelemente in zeitlicher Folge auf dem Halbleitersubstrat angeordnet sind.

**Revendications**

1. Dispositif de formation d'images à l'état solide comprenant: un circuit intégré à semiconducteurs, dans lequel une pluralité d'éléments de commutation (4, 4') sont disposés sur un substrat semiconducteur (11), les éléments de commutation étant aptes à sélectionner des positions d'éléments d'image par "mise à l'état conducteur" et "mise à l'état bloqué" des éléments de commutation selon une séquence temporelle; une pellicule photoconductrice (5') qui est disposée sur le circuit intégré et qui est raccordée à une extrémité (9) de chacun des éléments de commutation; et une électrode (7) de transmission de la lumière, qui est disposée sur la pellicule photoconductrice; chacun des éléments de commutation incluant des première et seconde régions d'impuretés (9, 7) situées dans le substrat semiconducteur et qui possèdent un type de conductivité opposé à celui du substrat semiconducteur, l'une des régions d'impuretés (9) agissant de manière à stocker des porteurs produits sous l'effet de l'incidence de la lumière; et des moyens (12) servant à commander le courant dans une voie de courant entre les deux régions d'impuretés; caractérisé en ce que la tension de plaquage $(BV_j)$ de la jonction, qui est formée entre ledit substrat semiconducteur (11) et la région d'impuretés (9) qui stocke des porteurs produits sous l'effet de l'incidence de la lumière, est rendue inférieure à la tension de claquage $(BV_{DS})$ entre les première et seconde régions d'impuretés (9, 16).

2. Dispositif de formation d'image à l'état solide selon la revendication 1, dans lequel une région semiconductrice (14') entre les première et seconde régions d'impuretés (9, 16) possède le même type de conductivité qui celui dudit substrat semiconducteur (11) et possède une concentration en impuretés qui est supérieure à celle dudit substrat semiconducteur, ce qui a pour effet que se trouve établie la relation $BV_j < BV_{DS}$.

3. Dispositif de formation d'images à l'état solide selon la revendication 1, dans lequel une région (15, 18), qui possède le même type de conductivité que celui dudit substrat semiconducteur et qui possède une concentration en impuretés supérieure à celle dudit substrat semiconducteur est déposée au voisinage de la région d'impuretés (9) servant à stocker les porteurs produits sous l'effet de l'incidence de la lumière, ce qui a pour effet que la relation $BV_j < BV_{DS}$ est établie.

4. Dispositif de formation d'images à l'état solide selon la revendication 3, dans lequel la région (15) possédant la concentration en impuretés supérieure entoure la région d'impuretés (9) utilisée pour le stockage des porteurs.

5. Dispositif de formation d'images à l'état solide selon la revendication 3, dans lequel la région (18), qui possède la concentration supérieure en impuretés, est disposée en contact avec une partie de ladite région d'impuretés (9) servant au stockage des porteurs produits sous l'effet de l'incidence de la lumière.

6. Dispositif de formation d'images à l'état solide selon l'une quelconque des revendications précédentes, dans lequel des dispositifs d'exploration par balayage (1, 2) agencés de manière à placer à "l'état conducteur" et à "l'état bloqué", les éléments de commutation selon une séquence temporelle, sont disposés sur le substrat semi-conducteur.

# FIG. 1

## FIG. 2

## FIG. 3

## FIG. 4

## FIG. 5

## FIG. 6

## F I G. 7

## F I G. 8